# EUROPEAN PATENT APPLICATION

(11) **EP 4 207 958 A1**
(43) Date of publication of application: **05.07.2023**
(21) Application number: 21868365.4
(22) Date of filing: 13.08.2021
(51) Int. Cl.: H05K 5/02, H05K 7/14, H05K 7/20

(54) **EXPANSION COMPONENT FOR ELECTRONIC DEVICE, AND ELECTRONIC DEVICE**

(30) Priority: 18.09.2020 CN 202010985749
(71) Applicant: Huawei Technologies Co., Ltd., Shenzhen, Guangdong 518129 (CN)
(72) Inventor: WAN, Junping, Shenzhen, Guangdong 518129 (CN)
(74) Representative: Gill Jennings & Every LLP
(86) International application number: PCT/CN2021/112468
(87) International publication number: WO 2022/057537

(57) **Abstract**

This application relates to the field of terminal technologies, and in particular, to an expansion component for an electronic device and an electronic device. This can resolve a problem in the prior art that it is difficult for a user to configure an expansion component because functions in the expansion component cannot be easily expanded or replaced. This application provides an expansion component including a housing, a backplane, and an expansion board. The housing has an accommodation cavity and a receptacle that is in communication with the accommodation cavity, and both the backplane and the expansion board are disposed in the accommodation cavity. The expansion board includes a board body, and a first connector and a first seal that are provided on the board body. The board body is inserted into the receptacle, and the first connector is connected to the backplane and the first seal blocks the receptacle. The expansion board in this application is detachably disposed in the housing. Therefore, when a different function is required, the expansion board may be directly replaced.

## Description

### CROSS-REFERENCE TO RELATED APPLICATIONS

This application claims priority to Chinese Patent Application No. 202010985749.1, filed with the China National Intellectual Property Administration on September 18, 2020 and entitled "EXPANSION COMPONENT FOR ELECTRONIC DEVICE AND ELECTRONIC DEVICE", which is incorporated herein by reference in its entirety.

### TECHNICAL FIELD

This application relates to the field of terminal technologies, and in particular, to an expansion component for an electronic device and an electronic device.

### BACKGROUND

A camera is more widely used in the fields such as transportation and campus surveillance in our daily life. In terms of function, the camera has evolved from simply recording an image to having an ability to analyze the image in real time, such as facial recognition and license plate recognition. However, in real-world application, different functional components of the camera are configured based on real-world application scenarios. However, for an outdoor camera, requirements on air tightness and waterproofing are high, and therefore the outdoor camera cannot be optionally configured at a project site. Generally, the outdoor camera needs to be assembled according to a specific configuration before delivery, leading to insufficient or redundant functions.

### SUMMARY

This application provides an expansion component for an electronic device and an electronic device, so that an expansion board in the expansion component can be easily replaced, thereby alleviating a problem that it is difficult for a user to configure an expansion component.

According to a first aspect, this application provides an expansion component, and the expansion component may be used in a camera. The expansion component includes a housing, a backplane, and an expansion board. The housing has an accommodation cavity, and the backplane is disposed in the accommodation cavity. The housing is further provided with a receptacle that is in communication with the accommodation cavity. The expansion board includes a board body, a first connector and a first seal. The board body is inserted into the receptacle, and the first connector is connected to the backplane and the first seal blocks the receptacle, so that when the expansion board is inserted into the housing, a space inside the accommodation cavity is enclosed. In the expansion component provided in this application, the expansion board is detachably mounted on the housing by using the receptacle. When a function of the expansion board needs to be adjusted, an original expansion board may be removed, and an expansion board with a new function is inserted into the housing and connected to the backplane. In real-world application, a required expansion board may be mounted in an expansion component before delivery, or the required expansion board may be inserted into the expansion component at a project site. This improves flexibility, and avoids undesirable problems such as insufficient or redundant functions.

During specific implementation, to ensure stability of mounting the expansion board on the housing, a mounting portion is provided on the board body, and the mounting portion is fastened to the housing. Specifically, the mounting portion may be a fastening panel. The fastening panel and the housing are connected in a plurality of manners. For example, the fastening panel is provided with first connection holes, the housing is provided with second connection holes, and the first connection holes correspond to the second connection holes. Fasteners (such as bolts) connect the fastening panel to the housing through the first connection holes and the second connection holes. Alternatively, a clamping buckle is provided on a side that is of the fastening panel and that faces the housing, and the housing is provided with an opening, so that the clamping buckle fastens the fastening panel through the opening. During fastening of the fastening panel on the housing, the first seal (such as a sealing ring) is sleeved on the board body, and the first seal is located between the housing and the fastening panel, to seal the receptacle.

In addition, to facilitate matching between the expansion board and the backplane, the board body is provided with the first connector, the backplane is provided with a second connector (a connector or a metal finger), and the second connector is connected to the first connector. Moreover, the board body is a PCB single board.

During specific implementation, to improve an expansion capability of the expansion component, there may be provided a plurality of receptacles and a plurality of expansion boards. Specifically, the plurality of receptacles are disposed in a one-to-one correspondence with the plurality of expansion boards, and each expansion board may have a different function. When a function of the expansion board needs to be adjusted, one or more of the plurality of expansion boards are detached, and an expansion board with a new function is inserted into the housing. Alternatively, a quantity of receptacles is greater than a quantity of expansion boards, and a redundant receptacle is matched with an auxiliary panel (the quantity of receptacles is the sum of the quantity of expansion boards and a quantity of auxiliary panels). The auxiliary panel can be inserted into the receptacle, and can block the receptacle. When there is a need to add a function to the expansion component, the auxiliary panel may be directly detached, and an expansion board with the new function is inserted into a position of the original auxiliary panel, so that not only function adjustment of the expansion component can be improved, but also no undesirable problems such as insufficient or redundant functions will be caused.

In addition, during specific implementation, the housing may be a one-piece structural member, or may be assembled by a plurality of parts.

For example, the housing may include an inner housing and an outer housing. The outer housing is sleeved on an outer periphery of the inner housing, and the inner housing and the outer housing define the accommodation cavity for accommodation the backplane. An inner periphery of the inner housing forms a heat dissipation channel. When gas passes through the heat dissipation channel, heat dissipation may be performed on the backplane disposed in the accommodation cavity and the expansion board matched with the backplane. In addition, the inner housing may be of a tubular structure, and the outer housing may be similar to the inner housing in terms of shape, or may have other regular or irregular shapes.

During specific implementation, the backplane may be disposed in a plurality of forms in the accommodation cavity. For example, the backplane is sleeved on the outer periphery of the inner housing (the inner housing passes through the backplane), and correspondingly, the expansion board may be disposed on the backplane circumferentially around the inner housing, thereby improving heat dissipation efficiency of the heat dissipation channel for the expansion board. Alternatively, the backplane is disposed between an outer wall of the inner housing and an inner wall of the outer housing, and correspondingly, the expansion boards may be disposed on the backplane in an evenly spaced-apart relation in a direction from the outer wall to the inner wall.

During specific implementation, the outer housing includes an upper cap and a base, and the inner housing is located in a space defined by the base and the upper cap. To ensure tightness of the accommodation cavity, a portion at which the upper cap is connected to the base may be provided with a second seal (a sealing ring) or may be applied with sealant.

In real-world application, when the expansion board is a wireless communication expansion board (including a radar, a Wi-Fi component, and a 4G communication component), to prevent the outer housing from functioning as a shield against the expansion board, the outer housing (the upper cap) may be made of a non-electromagnetic shielding material such as polycarbonate, ABS plastic (including a copolymer of acrylonitrile, butadiene and styrene), and the like, so that normal operation of the expansion board is ensured.

In addition, to improve a heat dissipation capability of the expansion component, in some implementations, the heat dissipation channel is further provided with an air blower, and the air blower may be fixedly mounted in a ventilation channel or at another location, to increase a flow velocity of airflow flowing through the ventilation channel, thereby improving the heat dissipation capability of the expansion component.

During specific implementation, the expansion component may further be provided with one or more high-power single boards (boards having CPUs), and a required high-power single board of the one or more high-power single boards may be mounted in the expansion component before delivery, or alternatively, the required high-power single board may be mounted in the expansion component at a project site. During specific mounting of a high-power single board, the high-power single board is disposed in the accommodation cavity and is in thermal contact with the inner housing, so that heat dissipation is performed on the high-power single board by using airflow in the heat dissipation channel. In addition, the high-power single board may be a communication channel such as a radar, a Wi-Fi component, a 4G communication component, a 5G communication component, or a Bluetooth component. The high-power single board may also be a device such as a graphics processing unit, an Ai processing chip, or a memory.

In addition, the expansion component may be used in an outdoor environment, and therefore, for the purpose of more effectively using the expansion component and protecting the outer housing from undesirable conditions such as an excess temperature that is caused by exposure to sunlight or the like, the expansion component further includes a shielding cover. The shielding cover is disposed on the top of and an outer periphery of the housing to protect the housing. In addition, a ventilation hole is provided on the top of the shielding cover, and airflow flowing through the ventilation channel may also be discharged via the ventilation hole of the shielding cover. Therefore, the shielding cover does not function as an obstacle to the ventilation channel of the inner housing, and thus does not affect heat dissipation performance of the expansion component.

This application further provides an electronic device. The electronic device includes a connecting component and a main device component. The connecting component is configured to connect the main device component to the expansion component. During specific disposing, because the expansion component is independent of the main device component, when a function of the main device component needs to be adjusted, function adjustment may be directly performed on the expansion component, thereby improving applicability of the electronic device.

### BRIEF DESCRIPTION OF DRAWINGS

FIG. 1 is a schematic exploded view depicting a structure of an expansion component according to an embodiment of this application;
FIG. 2 is a schematic sectional view depicting a structure of an expansion component according to an embodiment of this application;
FIG. 3 is a schematic exploded view depicting a structure of an expansion board in an expansion component according to an embodiment of this application;
FIG. 4 is an exploded view of an expansion component according to an embodiment of this application;
FIG. 5 is a schematic sectional view depicting a structure of another expansion component according to an embodiment of this application;
FIG. 6 is an exploded view of still another expansion component according to an embodiment of this application;
FIG. 7 is an exploded view of an expansion component according to an embodiment of this application;
FIG. 8 is a schematic sectional view depicting a structure of an expansion component according to an embodiment of this application;
FIG. 9 is a schematic sectional view depicting a structure of another expansion component according to an embodiment of this application;
FIG. 10 is a schematic sectional view depicting a structure of another expansion component according to an embodiment of this application;
FIG. 11 is a schematic sectional view depicting a structure of another expansion component according to an embodiment of this application;
FIG. 12 is a schematic sectional view depicting a structure of another expansion component according to an embodiment of this application;
FIG. 13 is a schematic diagram depicting a structure of an electronic device according to an embodiment of this application; and
FIG. 14 is another schematic diagram depicting a structure of another electronic device according to an embodiment of this application.

### Reference Sign:

10 - housing; 11 - receptacle; 12 - outer housing; 121 - upper cap; 122 - base; 123 - second seal; 124 - accommodation cavity; 13 - inner housing; 131: heat dissipation channel; 132: air blower; 20 - backplane; 21 - second connector; 30 - expansion board; 31 - board body; 32 - first connector; 33 - first seal; 34 - fastening panel; 341 - first connection hole; 35 - fastener; 40 - auxiliary panel; 50: high-power single board; 60 - shielding cover; 61 - shielding plate; 70 - connecting component; 80 - main device component.

### DESCRIPTION OF EMBODIMENTS

To make objectives, technical solutions, and advantages of this application clearer, the following further describes this application in detail with reference to the accompanying drawings.

An expansion component provided in this application may be used in a main device component such as a camera or an outdoor base station to expand and improve functions of the corresponding main device component. A camera is used as an example. Currently, instead of simply recording an image, the camera has evolved into having an ability to analyze the image in real time, such as performing facial recognition and license plate recognition. However, function components inside the camera increase with continuous adding of functions of the camera, and the functions of the camera are generally preset before delivery. Moreover, the camera needs to be sealed internally due to the presence of a lens component. Consequently, if users need to change a function of the camera or to add a new function during using, an undesirable condition such as insufficient or redundant functions may occur for some users, because the functions of the camera have been preset before delivery. In addition, some cameras include expansion components, so that when function expansion or adjustment is performed on the cameras, housings of the expansion components need to be detached, and then high-power single boards are replaced. It is understood that the foregoing is briefly illustrated only by using the camera as the example. However, in real-world application, if a high-power single board is mounted on a main device component such as an outdoor base station (for example, a base station for receiving and transmitting a wireless signal), technical problems that are the same as or similar to that of the foregoing camera also exist.

Terms used in the following embodiments are merely for the purpose of describing particular embodiments, but are not intended to limit this application. The terms "one", "a" and "this" of singular forms used in this specification and the appended claims of this application are also intended to include expressions such as "one or more", unless otherwise specified in the context clearly.

Referring to "one embodiment" or "some embodiments" or the like described in this specification means that one or more embodiments of this application include a specific feature, structure, or characteristic described in combination with the embodiment(s). Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "have", and their variants all mean "include but are not limited to", unless otherwise specifically emphasized in another manner.

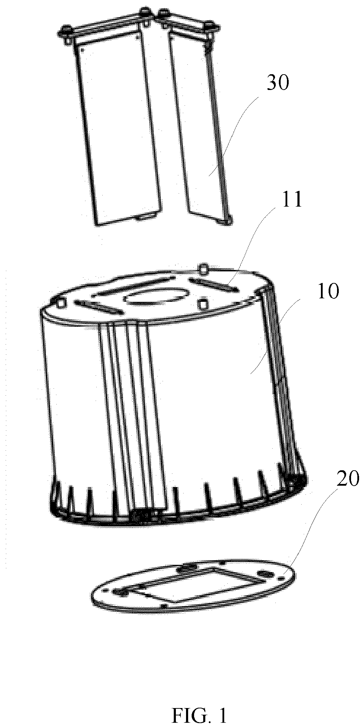

Referring to FIG. 1, in an embodiment provided in this application, an expansion component includes a housing 10, a backplane 20, and an expansion board 30. The housing 10 has an accommodation cavity (not shown in the figure), and the backplane 20 is disposed in the accommodation cavity. In addition, the housing 10 is provided with a receptacle 11 that is in communication with the accommodation cavity, and the expansion board 30 may be detachably connected to the backplane 20 through the receptacle 11. Because the expansion component is an independent component, when the expansion component is mounted on a camera and the camera has different function requirements, a required expansion board 30 may be directly mounted on the backplane 20 through the receptacle 11, or one or more original expansion boards 30 may be detached and replaced with one or more required expansion boards 30, to perform function adjustment on the expansion component. In real-world application, the expansion board 30 may be mounted in the expansion component before delivery, or an expansion board 30 with a corresponding function may be mounted on site according to an actual requirement. In addition, there is no need to detach and assemble the expansion component and the camera to mount the expansion board 30 in the expansion component, so that greater flexibility is obtained, and no undesirable problem such as insufficient or redundant functions will be caused. In addition, when the expansion board 30 is mounted on the expansion component, the expansion board 30 is sealedly connected to the housing 10 on the expansion component, thereby preventing impurities such as moisture and dust from entering the accommodation cavity, and improving operation stability of the backplane 20 and the expansion board 30.

When the expansion board 30 needs to rely on a wireless signal to perform signal transmission with the ambient (for example, the expansion board 30 includes a Wi-Fi component, a 4G communication component, and the like), to prevent the housing 10 from functioning as a shield against the expansion board 30, the housing 10 may be made of a non-electromagnetic shielding material such as polycarbonate, ABS plastic (including a copolymer of acrylonitrile, butadiene and styrene), and the like, so that normal operation of the expansion board 30 is ensured.

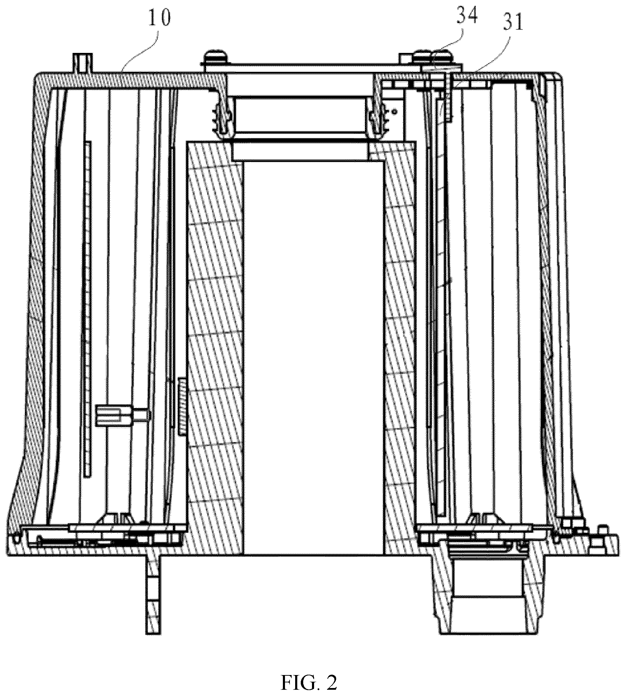

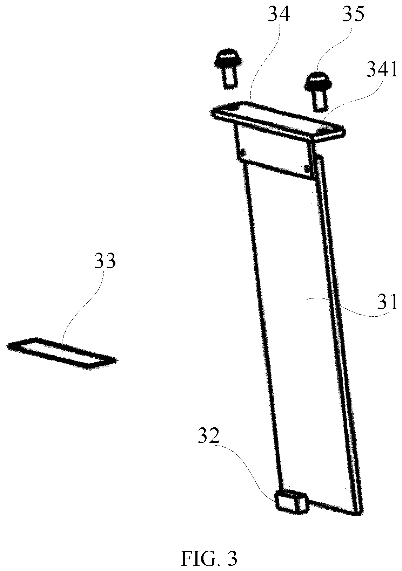

Referring to FIG. 2 and FIG. 3, an expansion board may include a board body 31, a first connector 32, and a first seal 33. The first connector 32 is mounted on an end of the board body 31, and the first connector 32 is configured to cooperate with a second connector provided on a backplane (not shown in the figure), to achieve an electrical connection between the expansion board and the backplane. The first seal 33 can provide sealing between the board body 31 and a receptacle, so that when the expansion board is mounted on a housing 10, tightness of the housing 10 is not affected. In addition, to improve stability of mounting the expansion board on the housing 10, a mounting portion is provided on the board body 31, and the mounting portion is configured to connect to the housing 10.

During specific configuration, the first connector 32 is connected to the second connector on the backplane, thereby facilitating implementation of a quick connection between the expansion board and the backplane.

In addition, during specific configuration, the first seal 33 may be a sealing ring, a gasket, or the like, and this is not limited in this application.

During specific configuration, the mounting portion may have a plurality of structural forms. For example, the mounting portion is configured as a fastening panel 34, and the fastening panel 34 is disposed at an end that is of the board body 31 and that is away from the first connector 32; and the fastening panel 34 is provided with first connection holes 341, the housing is provided with second connection holes, and fasteners 35 (screws) are connected to nuts on the housing 10 through the first connection holes 341 and the second connection holes, so that the mounting portion is fastened to the housing 10. However, during specific disposing of the first connection holes 341 and the second connection holes, the first connection holes 341 may be disposed in a spaced-apart relation along an extension direction of the fastening panel 34, provided that parts of the first connection holes 341 are corresponding to the second connection holes; and both the first connection hole 341 and the second connection holes may be threaded holes, or either one of the first connection holes and the second connection holes may be at least threaded holes. Alternatively, the mounting portion includes the fastening panel 34, a clamping buckle (a projection) is provided on a side that is of the fastening panel 34 and that faces the housing, and the housing is provided with an opening corresponding to the clamping buckle, so that the clamping buckle fastens the fastening panel to the housing through the opening.

It should be noted that, to enable more convenient connection between the fastening panel 34 and the board body 31, a connecting plate may be provided under the fastening panel 34. The connecting plate is perpendicular to the fastening panel 34, that is, a cross section of a structure formed by the fastening panel 34 and the connecting plate may be T-shaped, so that the end that is of the board body 31 and that is away from the first connector 32 is connected to the connecting plate by using a screw, bonding, or the like.

The fastening panel 34 and the connecting plate may be connected in a plurality of manners. For example, the fastening panel 34 and the connecting plate may be a one-piece member, or the fastening panel and the connecting plate may be detachably connected, and specific detachable manners are not listed herein. In addition, the fastening panel 34 and the connecting plate may also be disposed at an acute angle, as long as it is ensured that the expansion board can be connected to the backplane.

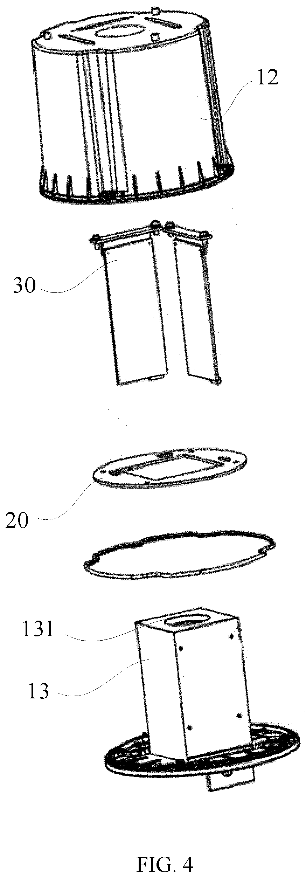

Referring to FIG. 4, during specific implementation, to improve a heat dissipation capability of an expansion component, a heat dissipation channel 131 may be further provided in the expansion component (in a housing). Specifically, heat generated in an accommodation cavity may be quickly carried away by airflow in the heat dissipation channel 131, thereby dissipating heat in the accommodation cavity. The heat dissipation channel 131 may be formed in a plurality of manners. For example, the housing includes an inner housing 13 and an outer housing 12. The outer housing 12 is sleeved on an outer periphery of the inner housing 13, an inner periphery of the inner housing 13 forms the foregoing heat dissipation channel 131, and the outer periphery of the inner housing 13 and the outer housing 12 define the accommodation cavity for accommodation a backplane 20 and an expansion board 30. Alternatively, it is understood that the expansion component further includes a ventilation duct. The ventilation duct passes through the housing, and a portion at which the ventilation duct is connected to the housing is sealed, so that the ventilation duct may form the foregoing heat dissipation channel.

The heat dissipation channel 131 may have various structures. For example, a cross section of the heat dissipation channel 131 may be rectangular, circular, or have other polygonal structures. The heat dissipation channel 131 may be rectilinear, curved, or dogleg.

During specific implementation, to improve a heat dissipation capability of the heat dissipation channel 131, the inner housing 13 may be made of a material (such as aluminum or aluminum alloy) with relatively strong thermal conduction. In addition, a structure such as a heat dissipation fin, a heat sink, and a heat pipe may also be provided on an inner wall of the inner housing 13 (the heat dissipation channel), to improve heat dissipation performance of the inner housing.

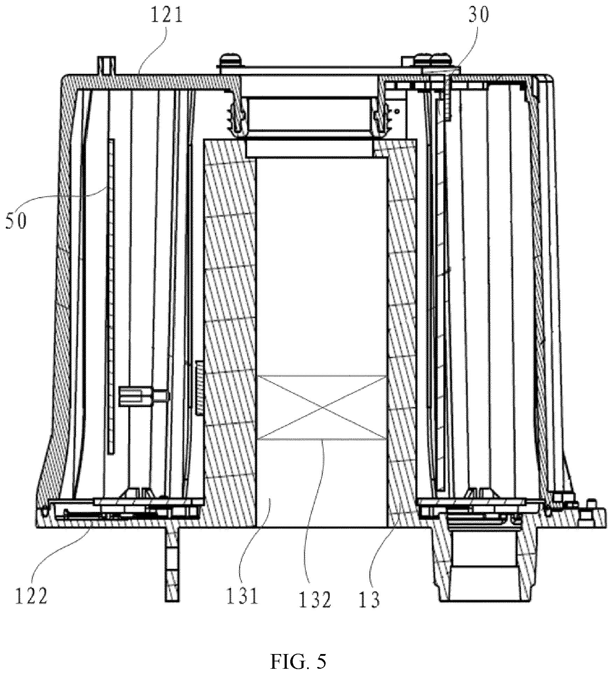

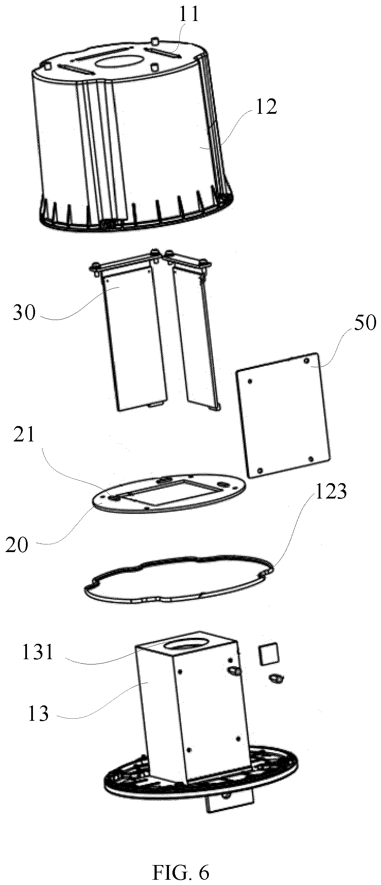

Referring to FIG. 5 and FIG. 6, in some embodiments, to improve functionality of an expansion component, one or more high-power single boards 50 may be further provided in the expansion component, and the high-power single boards 50 are connected to a backplane 20. The one or more high-power single boards 50 are disposed in an accommodation cavity. Because a high-power single board 50 generally has relatively high power, a heat emitting element in the high-power single board 50 is in thermal contact with an inner housing 13 through a thermally conductive buffer material (a thermally conductive pad, thermally conductive silicon, or the like), and heat dissipation is performed on the high-power single board 50 by using airflow in a heat dissipation channel 131. In this way, the expansion component can ensure a heat dissipation capability while adding functions. In addition, when the high-power single board 50 is in thermal contact with the inner housing 13, the backplane 20 may also be sleeved outside the inner housing 13. In this case, both a receptacle 11 on an outer housing 12 and a second connector 21 on the backplane 20 are circumferentially distributed around the inner housing 13. Moreover, the second connector 21 and the receptacle 11 are correspondingly disposed, so that an expansion board 30 may be disposed between the high-power single board 50 and the outer housing 12, and a plurality of expansion boards 30 may also be spaced apart in the same direction. Specifically, when the expansion component is mounted on a camera, the expansion component needs to be connected to a camera component of the camera. In this case, a cable channel is provided on a housing, an end of a first connecting cable is connected to the backplane 20 via the cable channel, and a second connecting cable is connected to the camera component. The first connecting cable and the second connecting cable are connected to each other, so that the expansion component is connected to the camera component, thereby implementing function expansion of the camera. Because the expansion component is an independent component, when a high-power single board is mounted, the camera is not affected, and the high-power single board may be replaced after delivery, so that the high-power single board provides greater flexibility.

In addition, still referring to FIG. 5, in some embodiments, an air blower 132 may be further provided in the expansion component. For example, the air blower 132 may be fixedly mounted in the heat dissipation channel 131 or at another location, to increase a flow velocity of airflow flowing through the heat dissipation channel 131, thereby improving the heat dissipation capability of the expansion component. During specific implementation, a type of the air blower 132 may be selected to have strong performance such as water resistance, dust resistance, and vibration resistance, to improve reliability and stability of the air blower 132.

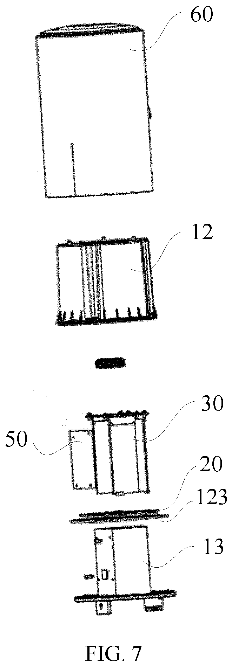

Continuing referring to FIG. 5 to FIG. 7, during specific implementation, the inner housing 13 and the outer housing 12 may be sealedly connected in a plurality of manners. To implement a sealed connection between the inner housing and the outer housing 13, the outer housing may include a base 122 and an upper cap 121, and the inner housing 13 is disposed in a space defined by the base 122 and the upper cap 121. Specifically, the upper cap 121 and the base 122 may be connected by using a second seal 123 (a sealing ring) or by applying sealant. The inner housing 13 has a first end connected to the upper cap 121 and a second end connected to the base 122, and both the upper cap 121 and the base 122 are provided with through holes that are in communication with the heat dissipation channel 131 that is formed in the inner housing 13. The inner housing 13 may be connected, by applying sealant or by welding, to a side that is of the upper cap and that faces the base 122 and a side that is of the base and that faces the upper cap 121, or an outer lateral wall of the inner housing 13 is connected, by applying sealant or by welding, to inner walls of the through holes that are on the upper cap 121 and the base 122.

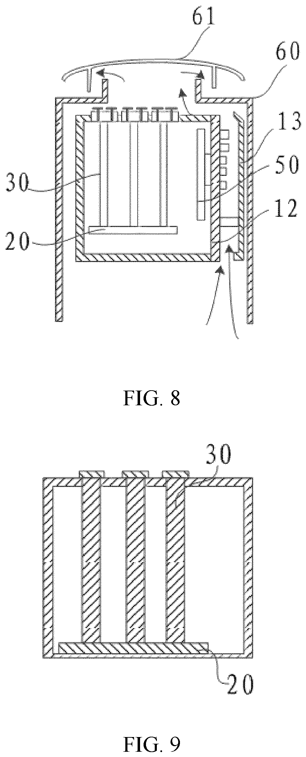

Referring to FIG. 8, an inner housing 12 is located on a side of an outer housing 13, a side that is of the inner housing 12 and that is proximate to the outer housing 13 overlaps with the outer housing (this portion is disposed integrally), and a heat dissipation channel is located at an edge position. In real-world application, an expansion component may be used in a relatively harsh environment such as outdoors. Therefore, to ensure operation stability of the expansion component, the expansion component may include a shielding cover 60. The shielding cover 60 may cover an outer periphery of and the top of the outer housing 13, and a ventilation hole that is in communication with the heat dissipation channel is provided at the top of the shielding cover, so that airflow flowing through the heat dissipation channel can flow out via the ventilation hole. In this way, when the shielding cover 60 protects the outer housing 13, heat dissipation of an expansion board 30 and a high-power single board 50 that are in the expansion component is not affected. To prevent foreign objects such as dust and leaves from entering the heat dissipation channel, a shielding plate may be provided on the top of the shielding cover 60, and an outer profile of the shielding plate 61 is greater than an aperture of the ventilation hole. Alternatively, the ventilation hole may be disposed on a lateral face of the top of the shielding cover 60, and a curved or corner structure is formed between the ventilation hole and the heat dissipation channel, so that rainwater entering the heat dissipation channel through the ventilation hole can be reduced. The shielding plate and the shielding cover 60 may be molded into a one-piece structure by using a process such as injection molding. Alternatively, the shielding plate 61 and the shielding cover 60 are separately manufactured by a process such as injection molding, and then connected by bonding or screw connection. However, during specific implementation, the shielding cover 60 and the shielding plate may be made of a non-electromagnetic shielding material such as polycarbonate, ABS plastic (including a copolymer of acrylonitrile, butadiene and styrene), and the like, so that no electromagnetic shielding will be generated for the expansion board and the high-power single board.

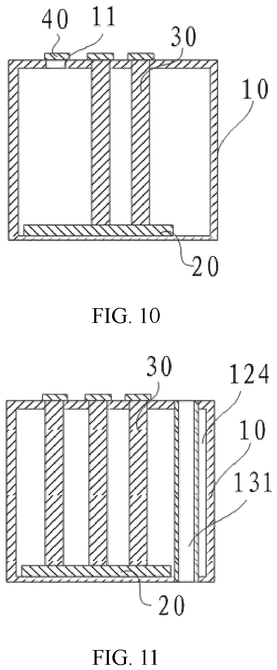

Continuing referring to FIG. 9, in some embodiments, to ensure an expansion capability of an expansion component, there may be a plurality of receptacles (not shown in the figure) and a plurality of expansion boards 30. Specifically, each receptacle is inserted with one expansion board 30, and each expansion board 30 may have a different function. Moreover, when a function of the expansion component needs to be adjusted, some of the expansion boards 30 may be detached and replaced with an expansion board 30 with a required function. However, during real-world application, the expansion boards 30 mounted on a backplane 20 may be mounted before delivery, and may alternatively be mounted at a project site, or some of the expansion boards 30 may be replaced, so that the expansion component provides greater flexibility, thereby avoiding causing undesirable problems such as insufficient or redundant functions. Continuing referring to FIG. 10, in some implementations, an expansion component further includes an auxiliary panel 40. In this case, a quantity of receptacles is a sum of a quantity of expansion boards 30 and a quantity of auxiliary panels 40, and the auxiliary panel 40 blocks a redundant receptacle 11 on a housing 10 in a detachable manner, to ensure tightness of the housing 10. A specific manner in which the auxiliary panel 40 blocks each of a plurality of receptacles 11 may be that a sealing ring is provided between the auxiliary panel 40 and the housing 10, and when two fastening screws fasten the auxiliary panel 40 to the housing 10, the sealing ring is located between the two fastening screws. When there is a need to add a function to the expansion component, the auxiliary panel 40 is detached, and an expansion board 30 with the new function is inserted into a backplane 20, thereby improving an expansion capability of the expansion component. In addition, during expansion, a main body of the expansion component does not need to be detached, thereby improving the ease of expansion.

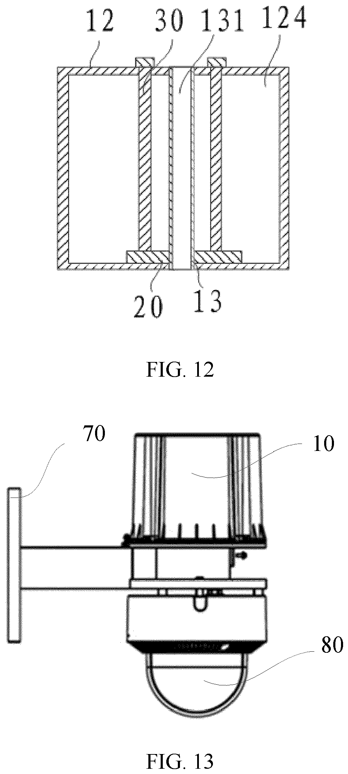

Continuing referring to FIG. 11, in some other embodiments, a heat dissipation channel 131 may be at various positions in the accommodation cavity 124. For example, the heat dissipation channel 131 is disposed on one side of the accommodation cavity 124, in which case a backplane 20 is provided on the other side of the accommodation cavity 124. A plurality of expansion boards 30 may be distributed in an array on the backplane 20. Continuing referring to FIG. 12, when a heat dissipation channel 131 is provided at a central position of an accommodation cavity 124 formed by an inner housing 13 and an outer housing 12, a backplane 20 may be sleeved on the inner housing 13, and an expansion board 30 partially mounted on the backplane 20 may be provided around the inner housing 13. In this way, heat generated on the expansion board 30 can be quickly carried away by the heat dissipation channel 131 formed on an inner periphery of the inner housing 13, thereby improving heat dissipation efficiency.

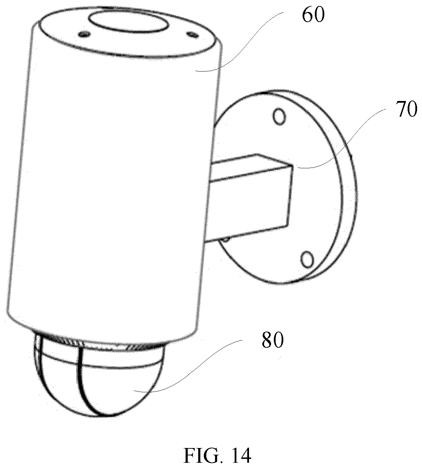

In FIG. 13, a housing 10 is connected to a connecting component 70. In FIG. 14, a shielding cover 60 is connected to the connecting component. Referring to FIG. 13 and FIG. 14, this application further provides an electronic device. The electronic device includes the connecting component 70 and a main device component 80. The connecting component 70 is configured to connect the main device component 80 to an expansion component. Specifically, the main device component 80 may be a camera component, the connecting component 70 may be a support, and the support may fasten the camera component onto a wall or a road surveillance pole. The camera component is fixedly mounted under the support, and there is a certain mounting clearance between the camera component and the support (i.e., a mounting clearance between a main device outer housing and the support). The expansion component may be mounted above the support, and external cold air may pass through the mounting clearance, so that heat generated in the camera component can be carried away, thereby improving a heat dissipation capability of the electronic device.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An expansion component for an electronic device, comprising:
a housing having an accommodation cavity, wherein the housing has a receptacle that is in communication with the accommodation cavity;
a backplane provided in the accommodation cavity; and
an expansion board comprising a board body, and a first connector and a first seal that are provided on the board body, wherein
the board body is inserted into the receptacle, the first connector is connected to the backplane, and the first seal blocks the receptacle.

2. The expansion component according to claim 1, wherein the board body has a mounting portion, and the mounting portion is fastened to the housing.

3. The expansion component according to claim 2, wherein the first connector is located at a first end of the board body, and the mounting portion is located at a second end of the board body, wherein
the first end and the second end are configured as two ends that face away from each other.

4. The expansion component according to claim 2 or 3, wherein the first seal is configured as a sealing ring, the sealing ring is sleeved and fastened on a periphery of the board body, and the sealing ring is located between the mounting portion and the first connector.

5. The expansion component according to any one of claims 2 to 4, wherein the mounting portion is configured as a fastening panel, and the fastening panel is connected to the board body; and
the fastening panel is provided with first connection holes, the housing is provided with second connection holes, and fasteners pass through and fasten the first connection holes and the second connection holes.

6. The expansion component according to any one of claims 2 to 5, wherein the backplane is provided with a second connector, and the second connector is configured to cooperate with the first connector.

7. The expansion component according to any one of claims 1 to 6, wherein there are a plurality of receptacles, and the plurality of receptacles are disposed in a one-to-one correspondence with a plurality of expansion boards.

8. The expansion component according to any one of claims 1 to 6, wherein a quantity of disposed receptacles is greater than a quantity of disposed expansion boards;
the expansion component further comprises an auxiliary panel, and the auxiliary panel is configured to be inserted into the receptacle and to block the receptacle; and
wherein the quantity of disposed receptacles is a sum of a quantity of expansion boards and a quantity of auxiliary panels.

9. The expansion component according to any one of claims 1 to 8, wherein the housing comprises an inner housing and an outer housing;
an inner periphery of the inner housing forms a heat dissipation channel;
the outer housing is disposed on an outer periphery of the inner housing, and the inner housing and the outer housing define the accommodation cavity; and
the backplane is disposed in the accommodation cavity.

10. The expansion component according to claim 9, wherein the backplane is sleeved on the outer periphery of the inner housing.

11. The expansion component according to claim 10, wherein the plurality of expansion boards are circumferentially arranged around the inner housing; or
the plurality of expansion boards are located on a side of the inner housing, and the plurality of expansion boards are spaced apart in a first direction.

12. The expansion component according to any one of claims 9 to 11, wherein the outer housing comprises an upper cap and a base, and the inner housing is located in a space defined by the base and the upper cap.

13. The expansion component according to claim 12, wherein the upper cap is made of a non-electromagnetic shielding material.

14. The expansion component according to any one of claims 9 to 13, further comprising an air blower, wherein the air blower is disposed in the heat dissipation channel.

15. The expansion component according to any one of claims 9 to 14, further comprising one or more high-power single boards, wherein the one or more high-power single boards are disposed in the expansion cavity, and the one or more high-power single boards are in thermal contact with the ventilation duct.

16. The expansion component according to any one of claims 9 to 15, further comprising a shielding cover, wherein
the shielding cover covers the top of and an outer periphery of the housing, and the shielding cover has, at the top, a ventilation hole that is in communication with the heat dissipation channel.

17. The expansion component according to claim 16, wherein the shielding cover is made of a non-electromagnetic shielding material.

18. The expansion component according to claim 16 or 17, wherein the shielding cover further covers an outer periphery of the outer housing, and there is a clearance between the shielding cover and the housing.

19. An electronic device, comprising the expansion component according to any one of claims 1 to 18, and further comprising a connecting component and a main device component, wherein the connecting component is configured to connect the main device component to the expansion component.
